# EUROPEAN PATENT APPLICATION

(11) **EP 4 647 780 A1**
(43) Date of publication of application: **12.11.2025**
(21) Application number: 23914677.2
(22) Date of filing: 05.01.2023
(51) Int. Cl.: G01R 27/02, G01R 31/00, G01R 31/389

(54) **DIAGNOSIS DEVICE FOR ELECTROCHEMICAL MODULE, DIAGNOSIS SYSTEM, DIAGNOSIS METHOD, AND DIAGNOSIS PROGRAM**

(71) Applicant: Kabushiki Kaisha Toshiba, Tokyo 105-0023 (JP)
(72) Inventor: FUKAYA, Taro, Tokyo 105-0023 (JP); KONDO, Asato, Tokyo 105-0023 (JP); KANAI, Yuta, Tokyo 105-0023 (JP); YAGI, Ryosuke, Tokyo 105-0023 (JP); SUGANO, Yoshitsune, Tokyo 105-0023 (JP); YOSHINAGA, Norihiro, Tokyo 105-0023 (JP)
(74) Representative: Marks & Clerk LLP
(86) International application number: PCT/JP2023/000089
(87) International publication number: WO 2024/147185

(57) **Abstract**

In an embodiment, a diagnosis apparatus for an electrochemical module in which at least one of an anode and a cathode includes a catalyst is provided, and the diagnosis apparatus includes an output circuit and a processor. The processor, in a state in which the operation power is input to the electrochemical module or the operation power is output from the electrochemical module, superimposes the inspection power on the operation power by supplying the inspection power from the output circuit to the electrochemical module, and measures measurement data for diagnosis by measuring a current and a voltage for the electrochemical module in a state in which the inspection power is superimposed on the operation power.

## Description

### FIELD

An embodiment of the present invention relates to a diagnosis apparatus, a diagnosis system, a diagnosis method, and a diagnosis program for an electrochemical module.

### BACKGROUND

An electrochemical module is used which generates an electrochemical reaction when operation power is input, or outputs operation power generated by the electrochemical reaction. In the electrochemical module to which the operation power is input, for example, electrolysis of water or the like is generated as an electrochemical reaction by the input of the operation power, and a product due to the electrochemical reaction such as hydrogen or the like is recovered. In the electrochemical module that outputs the operation power, the operation power is generated by the electrochemical reaction by being supplied with fuel such as hydrogen and oxygen, and the generated operation power is supplied.

The electrochemical module operated as described above is required to be appropriately inspected by diagnosing a state such as a deterioration state. In addition, it is required to inspect the electrochemical module without stopping the operation of the electrochemical module, that is, while continuing the operation of the electrochemical module.

### CITATION LIST

### PATENT LITERATURE

Patent Literature 1: Jpn. Pat. Appln. KOKAI Publication No. 2022-45497
Patent Literature 2: Jpn. Pat. Appln. KOKAI Publication No. 2014-154437
Patent Literature 3: Jpn. Pat. Appln. KOKAI Publication No. 2017-106889

### SUMMARY

### TECHNICAL PROBLEM

An object of the present invention is to provide a diagnosis apparatus, a diagnosis system, a diagnosis method, and a diagnosis program for an electrochemical module capable of appropriately inspecting the electrochemical module without stopping operation of the electrochemical module.

### SOLUTION TO PROBLEM

According to an embodiment, a diagnosis apparatus for an electrochemical module, in which at least one of an anode and a cathode includes a catalyst, and an electrochemical reaction occurs when operation power is input or operation power generated by an electrochemical reaction is output, is provided. The diagnosis apparatus includes an output circuit and a processor. The output circuit is capable of outputting inspection power. The processor, in a state in which the operation power is input to the electrochemical module or the operation power is output from the electrochemical module, superimposes the inspection power on the operation power by supplying the inspection power from the output circuit to the electrochemical module, and measures measurement data for diagnosis by measuring a current and a voltage for the electrochemical module in a state in which the inspection power is superimposed on the operation power.

### BRIEF DESCRIPTION OF THE DRAWINGS

FIG. 1 is a block diagram schematically illustrating an example of a diagnosis system according to an embodiment.
FIG. 2 is a flowchart schematically illustrating an example of processing performed by a processing circuit or the like of the diagnosis apparatus when measurement data for diagnosis is measured for each of a plurality of electrochemical modules of the diagnosis system according to the embodiment.
FIG. 3 is a flowchart schematically illustrating an example of processing of measuring measurement data for diagnosis for a measurement target module illustrated in FIG. 2.
FIG. 4 is a schematic diagram illustrating processing of changing a reference variable width related to a current value in the measurement target module illustrated in S112 of FIG. 3.
FIG. 5 is a flowchart schematically illustrating an example of processing in analysis of measurement data for diagnosis for an electrochemical module performed by a processing circuit of the diagnosis apparatus according to the embodiment.
FIG. 6 is a flowchart schematically illustrating an example of processing of controlling power input to a certain electrochemical module performed by a processing circuit of the diagnosis apparatus according to the embodiment in a state where diagnosis is not performed.

### DETAILED DESCRIPTION

Hereinafter, an embodiment will be described with reference to the drawings.

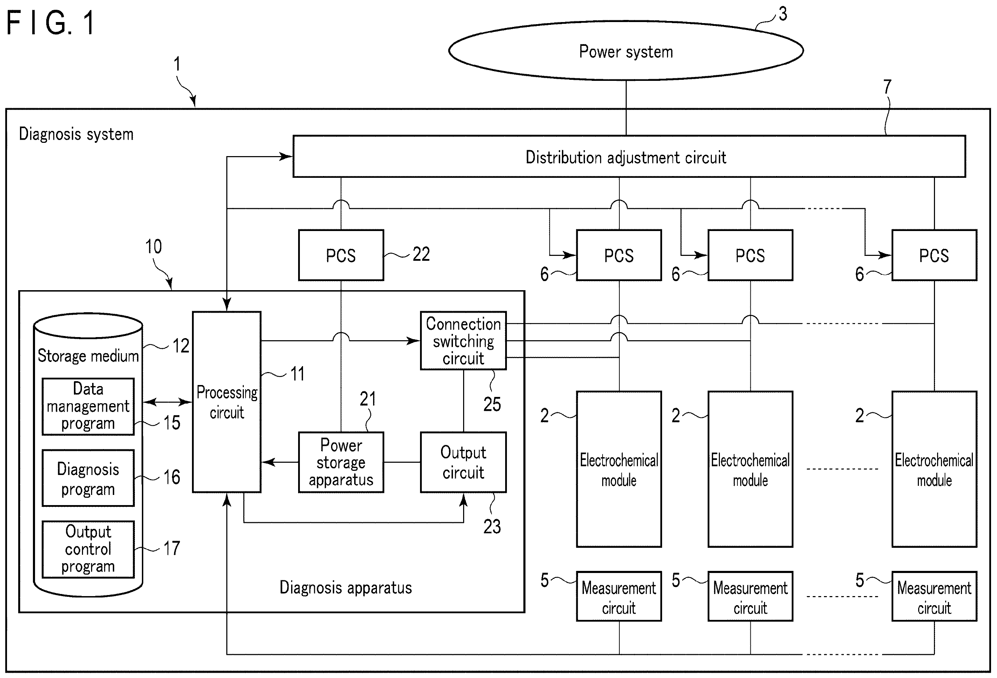

FIG. 1 illustrates an example of a diagnosis system 1 according to an embodiment. The diagnosis system 1 includes one or more electrochemical modules 2, and, in an example of FIG. 1, the diagnosis system 1 is provided with a plurality of electrochemical modules 2. Each of the electrochemical modules 2 can be connected to a power system 3, and the operation power, which is the power to be operated, is input to each of the electrochemical modules 2 through the power system 3. Examples of the power system 3 include a power system that supplies power from a generator that generates power using natural energy such as sunlight and wind power, and a power system that supplies power from a power plant. In an example, power from a generator that generates power using natural energy is supplied to the diagnosis system 1 through the power system 3, whereby the operation power is input to each of the electrochemical modules 2. In the example of FIG. 1, the plurality of electrochemical modules 2 can receive the operation power independently from each other, and the plurality of electrochemical modules 2 can communicate with the power system 3 independently from each other.

Each of the plurality of electrochemical modules 2 includes one or more electrochemical cells (not shown). When each of the electrochemical modules 2 includes a plurality of electrochemical cells, in each of the electrochemical modules 2, the plurality of electrochemical cells are electrically connected to each other. In this case, in each of the electrochemical modules 2, a plurality of electrochemical cells may be electrically connected in series, or a plurality of electrochemical cells may be electrically connected in parallel. In each of the electrochemical modules 2, both a structure in which a plurality of electrochemical cells are electrically connected in series and a structure in which a plurality of electrochemical cells are electrically connected in parallel may be formed.

In each of the electrochemical modules 2, each of the one or more electrochemical cells includes an anode and a cathode, and at least one of the anode and the cathode includes a catalyst. In the present embodiment, DC power is input to each of the electrochemical modules 2 as operation power. Then, in each of the electrochemical modules 2, an electrochemical reaction occurs in the electrochemical cell when the operation power is input. Then, the product generated by the electrochemical reaction in each of the electrochemical modules 2 is recovered.

In an example, each of the electrochemical modules 2 includes one or more water electrolysis cells as an electrochemical cell. Water is supplied to each of the electrochemical module 2. In this case, in each of the electrochemical modules 2 to be the water electrolysis module, hydrogen ions and oxygen are generated in each anode of the electrochemical cell by inputting the operation power. When the operation power is input to each of the electrochemical modules 2, hydrogen ions generated at the anode move to the cathode side in each electrochemical cell, and hydrogen is generated at the cathode. In this example, as described above, the electrolysis of water occurs as an electrochemical reaction by inputting the operation power in each of the electrochemical modules 2. Hydrogen, which is a product obtained by electrolysis of water, is recovered.

In an example, each of the electrochemical modules 2 includes one or more power to chemicals (P2C) cells as electrochemical cells. In each electrochemical module 2, water is supplied to the anode of each P2C cell, and carbon dioxide is supplied to the cathode of each P2C cell. In each electrochemical module 2, oxygen is generated from water at an anode of each electrochemical cell, and carbon monoxide is generated from carbon dioxide at a cathode of each electrochemical cell by inputting the operation power. In the present example, as described above, the electrolysis of water and carbon dioxide occurs as an electrochemical reaction by inputting the operation power in each of the electrochemical modules 2. Then, oxygen which is a product obtained by electrolysis of water and carbon monoxide which is a product obtained by electrolysis of carbon dioxide are recovered.

The diagnosis system 1 is provided with the same number of measurement circuits 5 as the number of electrochemical modules 2, and one measurement circuit 5 is provided for each of the electrochemical modules 2. Each of the measurement circuits 5 measures a current and a voltage for a corresponding one of the electrochemical modules 2. For example, each of the measurement circuits 5 measures a current input to a corresponding one of the electrochemical modules 2 and a voltage applied to the entire electrochemical module 2. In addition, each of the measurement circuits 5 may measure a temperature of a corresponding one of the electrochemical module 2. Therefore, each of the measurement circuits 5 may include an ammeter that measures current and a voltmeter that measures voltage, and may include a temperature sensor that measures temperature, and the like.

When a plurality of electrochemical cells are provided in each of the electrochemical modules 2, each of the measurement circuits 5 may measure any one of the current, the voltage, and the temperature of each of the plurality of electrochemical cells for a corresponding one of the electrochemical modules 2. In an example, in each of electrochemical modules 2, a plurality of electrochemical cells are electrically connected in series. Each of the measurement circuits 5 measures the current input to the corresponding one of the electrochemical modules 2, and measures the voltage of each of the plurality of electrochemical cells for the corresponding one of the electrochemical modules 2. In another example, a plurality of electrochemical cells are electrically connected in parallel in each of electrochemical modules 2. Each of the measurement circuits 5 measures the voltage applied to the whole of the corresponding one of the electrochemical modules 2, and measures the current of each of the plurality of electrochemical cells for the corresponding one of the electrochemical modules 2.

In the diagnosis system 1, the same number of PCSs (power conditioning subsystem) 6 as a power regulator as the electrochemical modules 2 are provided, and one PCS 6 is provided for each of the electrochemical modules 2. Each of the PCSs 6 converts power from the power system 3 and inputs the power to a corresponding one of the electrochemical modules 2. At this time, each of the PCSs 6 converts, for example, AC power from the power system 3 into DC power in a voltage range corresponding to the electrochemical module 2 by AC/DC conversion and transformation, and inputs the converted DC power as operation power to the corresponding one of the electrochemical modules 2.

In addition, each of the PCSs 6 adjusts the operation power input to the corresponding one of the electrochemical modules 2. Each of the PCSs 6 monitors the current and voltage at a corresponding one of the electrochemical modules 2. Each of the PCSs 6 adjusts the operation power input to the corresponding one of the electrochemical modules 2 such that the current value in the corresponding one of the electrochemical modules 2 falls within the range of the reference variable width around the target current value. For example, when the current value of the current input to the corresponding one of the electrochemical modules 2 fluctuates beyond the reference variable width with respect to the target current value, each of the PCSs 6 adjusts the voltage applied to the corresponding one of the electrochemical modules 2, or the like, to bring the current value of the current input to the corresponding one of the electrochemical modules 2 into a range of the reference variable width around the target current value.

In addition, the diagnosis system 1 is provided with a distribution adjustment circuit 7. The distribution adjustment circuit 7 is provided between each of the PCSs 6 and the power system 3, and can switch an electrical connection state of each of the electrochemical modules 2 to the power system 3. In the distribution adjustment circuit 7, an electrical connection state to the power system 3 can be switched for each electrochemical module 2. Accordingly, the plurality of electrochemical modules 2 can independently input the operation power to each other. The distribution adjustment circuit 7 adjusts the amount of power distributed to each of the electrochemical modules 2 electrically connected to the power system 3.

The diagnosis system 1 is provided with a diagnosis apparatus 10. The diagnosis apparatus 10 diagnoses an electrochemical module 2, and diagnoses a state such as a deterioration state of each of the plurality of electrochemical modules 2. The diagnosis apparatus 10 may diagnose a state such as a deterioration state of each of one or more electrochemical cells for each of the electrochemical modules 2. In an example, the diagnosis apparatus 10 is a processing apparatus (computer) such as a server, and includes a processing circuit 11 and a storage medium 12. The processing circuit 11 includes a processor, an integrated circuit, or the like, and the processor or the like constituting the processing circuit 11 includes any of a central processing unit (CPU), an application specific integrated circuit (ASIC), a microcomputer, a field programmable gate array (FPGA), a digital signal processor (DSP), and the like. The processing circuit 11 may include a processor or the like, or may include a plurality of processors or the like. The storage medium 12 is either a main storage apparatus such as a memory or an auxiliary storage apparatus. In the diagnosis apparatus 10, only one memory or the like to be the storage medium 12 may be provided, or a plurality of memories or the like may be provided.

The processing circuit 11 performs processing by executing a program or the like stored in the storage medium 12. For example, by executing a program or the like stored in the storage medium 12, the processing circuit 11 cooperates with the PCS 6 and the distribution adjustment circuit 7 to adjust the amount of power distributed to each of the electrochemical modules 2, or perform control to cause the current value in each of the electrochemical modules 2 to fall within the range of the reference variable width around the target current value. In addition, the processing circuit 11 acquires a measurement result in each of the measurement circuits 5.

In the example of FIG. 1, the storage medium 12 stores a data management program 15, a diagnosis program 16, and an output control program 17 as programs to be executed by the processing circuit 11. The processing circuit 11 executes the data management program 15 to write data to the storage medium 12 and read data from the storage medium 12. The processing circuit 11 executes the diagnosis program 16 to perform processing described later in the diagnosis of the states of the plurality of electrochemical modules 2. In addition, in a state where diagnosis is not performed, the processing circuit 11 controls power input to each of the electrochemical modules 2 by executing the output control program 17.

In an example, the diagnosis apparatus 10 is constituted of a plurality of processing apparatuses (computers) such as a plurality of servers, and the processors of the plurality of processing apparatuses cooperate to perform processing described later in the diagnosis of the electrochemical module 2. In another example, a part of the diagnosis apparatus 10 is constituted by a cloud server in a cloud environment. The infrastructure of the cloud environment includes a virtual processor such as a virtual CPU and a cloud memory. Then, the virtual processor performs processing described later in the diagnosis of the electrochemical module 2 instead of the processing circuit 11. The cloud memory has a function of storing programs, data, and the like, similarly to the storage medium 12.

In an example, a user interface may be provided in the diagnosis system 1. In this case, on the user interface, an operation or the like related to diagnosis of the diagnosis system 1 is input by a user or the like of the diagnosis system 1. Therefore, in the user interface, any of a button, a mouse, a touch panel, a keyboard, and the like is provided as an operation unit to which an operation is input by the user or the like. In addition, the user interface is provided with a notifier that notifies information related to diagnosis of the diagnosis system 1. The notifier notifies information by any of screen display, transmission of sound, and the like. Note that the user interface may be mounted on a processing apparatus constituting the diagnosis apparatus 10, or may be provided separately from the processing apparatus constituting the diagnosis apparatus 10.

In the example of FIG. 1, the diagnosis apparatus 10 includes a power storage apparatus 21 capable of storing power. The power storage apparatus 21 is, for example, either a storage battery or a capacitor. In addition, the diagnosis system 1 is provided with a PCS 22 as a power converter. The PCS 22 converts the power from the power system 3 and then inputs the power to the power storage apparatus 21 to charge the power storage apparatus 21. At this time, for example, the PCS 22 converts AC power from the power system 3 into DC power having a voltage range corresponding to the power storage apparatus 21 by AC/DC conversion and transformation, and inputs the converted DC power to the power storage apparatus 21.

In addition, the PCS 22 adjusts power input to the power storage apparatus 21. For example, the PCS 22 adjusts the power input to the power storage apparatus 21 in a state where the current value of the current input to the power storage apparatus 21 falls within the range of the reference variable width around the target current value. In the diagnosis system 1, the distribution adjustment circuit 7 is provided between the PCS 22 and the power system 3. The distribution adjustment circuit 7 can switch an electrical connection state of the power storage apparatus 21 to the power system 3. It is possible to input power from the power system 3 to the power storage apparatus 21 by the distribution adjustment circuit 7 independently of the electrochemical module 2. In a state where the power storage apparatus 21 is electrically connected to the power system 3, the distribution adjustment circuit 7 adjusts the amount of power distributed to the power storage apparatus 21.

The diagnosis apparatus 10 includes an output circuit 23 and a connection switching circuit 25. The output circuit 23 can output power such as inspection power to each of the electrochemical modules 2. The connection switching circuit 25 can switch an electrical connection state of each of the electrochemical modules 2 to the output circuit 23. The processing circuit 11 controls operations of the output circuit 23 and the connection switching circuit 25. By controlling the operations of the output circuit 23 and the connection switching circuit 25, the output state of power from the output circuit 23 to each of the electrochemical modules 2 is controlled.

The DC power discharged from the power storage apparatus 21 is supplied to the output circuit 23. The output circuit 23 can convert DC power into inspection power, and output the converted inspection power to each of the electrochemical modules 2. The output circuit 23 outputs, for example, AC power in which a current value periodically changes as inspection power. In this case, any one of a sine wave, a triangular wave, a sawtooth wave, and an M-sequence signal is output from the output circuit 23 as the AC current in which the current value periodically changes. In addition, the output circuit 23 can adjust the frequency of the output AC power, and can change the AC power to be the inspection power to a plurality of frequencies different from each other. The output circuit 23 can supply the DC power from the power storage apparatus 21 to each of the electrochemical modules 2 without performing power conversion or the like.

In the embodiment, diagnosis is performed on the plurality of electrochemical modules 2, and the following processing is performed by the diagnosis apparatus 10 or the like in one diagnosis. In one diagnosis, a state such as a deterioration state is diagnosed for each of the plurality of electrochemical modules 2. In addition, diagnosis of the electrochemical module 2 is periodically performed. The processing circuit 11 executes the diagnosis program 16 for each diagnosis. In one diagnosis of the electrochemical module 2, the processing circuit 11 causes the corresponding one of the measurement circuits 5 to measure measurement data for diagnosis for each of the plurality of electrochemical modules 2. The processing circuit 11 diagnoses the state of each of the electrochemical modules 2 by analyzing the measured measurement data for diagnosis.

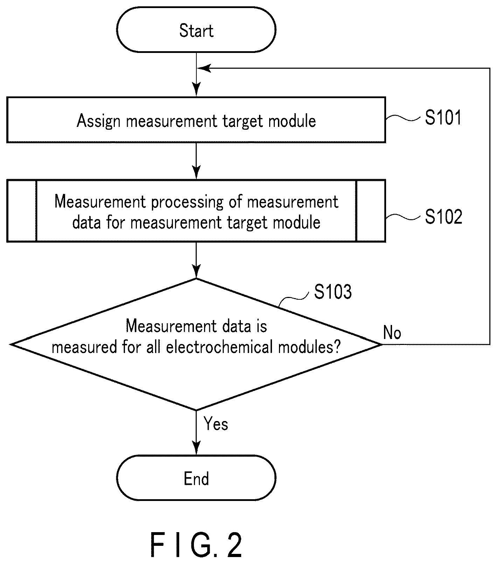

FIG. 2 is a flowchart illustrating an example of processing performed by the processing circuit 11 or the like of the diagnosis apparatus 10 when measurement data for diagnosis is measured for each of the plurality of electrochemical modules 2 of the diagnosis system 1. The processing in the example of FIG. 2 is performed in each diagnosis of the plurality of electrochemical modules 2. The processing in the example of FIG. 2 is performed in a state where the operation power is input to the plurality of electrochemical modules 2 in parallel. That is, in a state where the processing of the example of FIG. 2 is performed, the operation power is input to each of the electrochemical modules 2. When the processing of the example of FIG. 2 is started, the processing circuit 11 or the like assigns one of the plurality of electrochemical modules 2 to a measured target module (S101). Then, the processing circuit 11 or the like performs processing of measuring measurement data for diagnosis for the measurement target module (S102).

When the measurement of the measurement data for diagnosis for the measurement target module is completed by the processing of S102, the processing circuit 11 determines whether or not the measurement data for diagnosis has been measured for all of the plurality of electrochemical modules 2 of the diagnosis system 1 (S103). When the measurement data has been measured for all of the electrochemical modules 2 (S103-Yes), the processing of the example of FIG. 2 ends. On the other hand, when there exists the electrochemical module 2 for which the measurement data is not measured (S103-No), the processing returns to S101, and the processing circuit 11 assigns one of the plurality of electrochemical modules 2 to the measurement target module (S101). At this time, the electrochemical module 2 to be assigned to the measurement target module is changed from the previous assignment of the measurement target module. In addition, the measurement target module is assigned from the electrochemical module 2 for which the measurement data for diagnosis is not measured.

Since the processing as described above is performed, in the example of FIG. 2, the assignment of the measurement target module and the measurement of the measurement data for the measurement target module are repeated while sequentially changing the electrochemical module 2 to be assigned to the measurement target module until the measurement data is measured for all of the plurality of electrochemical modules 2 of the diagnosis system 1. In the example of FIG. 2, each of the assignment of the measurement target module in S101 and the measurement of the measurement data for diagnosis for the measurement target module in S102 is performed the same number of times as the number of electrochemical modules 2 provided in the diagnosis system 1.

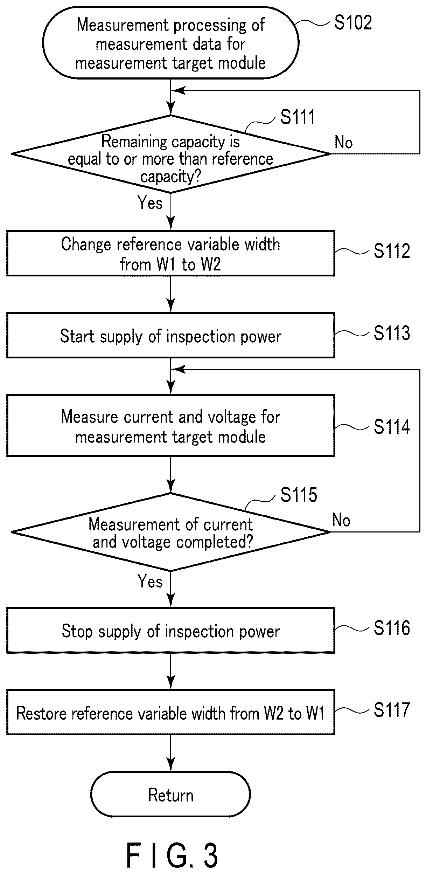

FIG. 3 is a flowchart illustrating an example of processing of measuring measurement data for diagnosis for the measurement target module illustrated in FIG. 2. When the processing of FIG. 3 is started, the processing circuit 11 or the like determines whether or not the remaining capacity of the power storage apparatus 21 is equal to or more than the reference capacity (S111). As a result, it is determined whether or not the remaining capacity of the power storage apparatus 21 is the capacity capable of outputting the inspection power from the output circuit 23. When the remaining capacity of the power storage apparatus 21 is less than the reference capacity (S111-No), the processing returns to S111. For this reason, the processing circuit 11 or the like stands by until the remaining capacity of the power storage apparatus 21 becomes equal to or more than the reference capacity by charging with the power input from the power system 3.

When the remaining capacity of the power storage apparatus 21 is equal to or more than the reference capacity (S111-Yes), the processing circuit 11 changes the reference variable width related to the current value in the measurement target module from the first variable width W1 to the second variable width W2 larger than the first variable width W1 (S112). At this time, the processing circuit 11 changes the reference variable width from the first variable width W1 to the second variable width W2 by, for example, changing the setting in the PCS 6 corresponding to the measurement target module.

The processing circuit 11 controls operations of the output circuit 23 and the connection switching circuit 25 to start output and supply of the inspection power from the output circuit 23 to the electrochemical module 2 assigned to the measurement target module (S113). Here, in a state where the inspection power is supplied from the output circuit 23 to the measurement target module, DC power is input to the measurement target module as the operation power. Therefore, by supplying the inspection power to the measurement target module, the inspection power is superimposed on the operation power to the measurement target module.

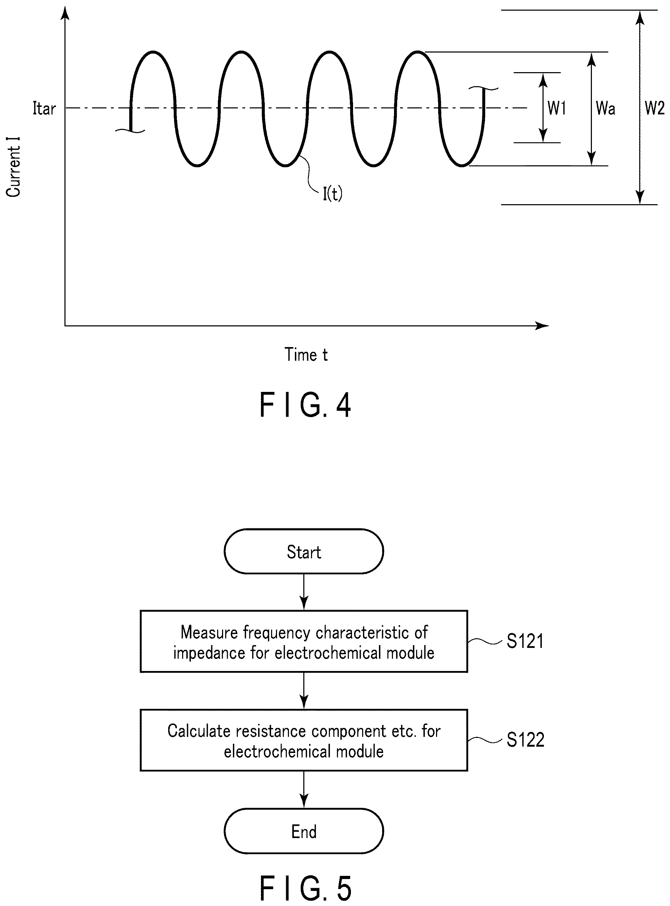

FIG. 4 describes processing of changing the reference variable width related to the current value in the measurement target module illustrated in S112 of FIG. 3. FIG. 4 illustrates a graph in which the abscissa axis represents time t and the ordinate axis represents current I. In addition, FIG. 4 illustrates a time change I(t) of the current input to the measurement target module in a state where the inspection power is superimposed on the operation power to the measurement target module. In an example of FIG. 4, the PCS 6 corresponding to the measurement target module adjusts the operation power input to the measurement target module in a state in which the current value of the current input to the measurement target module falls within the range of the reference variable width around the target current value Itar. Then, the output circuit 23 outputs AC power as the inspection power, and in the AC power as the inspection power, the current value periodically changes with a variable width (peak-to-peak value) Wa.

In the example of FIG. 4, the processing circuit 11 sets the reference variable width related to the current value in the measurement target module to the first variable width W1 in a state where the inspection power is not superimposed on the operation power to the measurement target module. Then, in cooperation with the PCS 6 corresponding to the measurement target module, the processing circuit 11 performs control to cause the current value of the current input to the measurement target module to fall within the range of the first variable width W1 around the target current value Itar. On the other hand, in a state where the inspection power is superimposed on the operation power to the measurement target module, the processing circuit 11 sets the reference variable width related to the current value in the measurement target module to the second variable width W2 larger than the first variable width W1. Then, in cooperation with the PCS 6 corresponding to the measurement target module, the processing circuit 11 performs control to cause the current value of the current input to the measurement target module to fall within the range of the second variable width W2 around the target current value Itar.

As illustrated in FIG. 4 and the like, in the present embodiment, the processing circuit 11 sets the second variable width W2, which is the reference variable width in a state where the inspection power is superimposed on the operation power to the measurement target module, to be larger than the variable width Wa of the current value in the AC power to be the inspection power. In the example of FIG. 4, the first variable width W1, which is the reference variable width in a state where the inspection power is not superimposed on the operation power to the measurement target module, is set to be smaller than the variable width Wa of the current value in the AC power to be the inspection power. However, if the first variable width W1 is smaller than the second variable width W2, the first variable width W1 may be equal to or larger than the variable width Wa of the current value in the AC power to be the inspection power.

In the measurement processing of the example of FIG. 3, when the supply of the inspection power to the measurement target module is started by the processing of S113, the processing circuit 11 measures the current and the voltage of the electrochemical module 2 assigned to the measurement target module (S114). As a result, the current and the voltage for the measurement target module are measured in a state where the inspection power is superimposed on the operation power. At this time, for example, the current input to the measurement target module and the voltage applied to the entire measurement target module are measured as the current and the voltage for the measurement target module. In the configuration in which the plurality of electrochemical cells are electrically connected in the measurement target module, the current flowing through each electrochemical cell in the state in which the inspection power is superimposed on the operation power may be measured as the current for the measurement target module, and the voltage applied to each electrochemical cell in the state in which the inspection power is superimposed on the operation power may be measured as the voltage for the measurement target module.

In a state where the current and the voltage of the measurement target module are measured, the processing circuit 11 superimposes the inspection power to be the AC power on the operation power to the measurement target module while sequentially changing the frequency to a plurality of different frequencies relative to each other. Then, in a state where the inspection power is superimposed at each of the plurality of frequencies, the current and the voltage for the measurement target module are measured. Then, as long as the measurement of the current and the voltage for the electrochemical module 2 assigned to the measurement target module is not completed (S115-No), the processing returns to S114, and the processing of S114, that is, the measurement of the current and the voltage for the measurement target module is continuously performed. By measuring the current and the voltage for the measurement target module as described above, measurement data for diagnosis is measured for the electrochemical module 2 assigned to the measurement target module.

When the measurement of the current and voltage of the measurement target module is completed (S115-Yes), the processing circuit 11 stops the output of the inspection power from the output circuit 23 to the measurement target module, and stops the supply of the inspection power to the measurement target module (S116). As a result, the inspection power is not superimposed on the operation power to the measurement target module. Then, the processing circuit 11 restores the reference variable width related to the current value in the measurement target module from the second variable width W2 to the first variable width W1 (S117). As a result, the reference variable width related to the current value in the measurement target module is narrowed.

In the present embodiment, by performing the processing of the example of FIGS. 2 and 3, in a state where the operation power is input to the plurality of electrochemical modules 2 in parallel, the processing circuit 11 sequentially changes the electrochemical modules 2 in which the inspection power is superimposed on the operation power, and sequentially measures the measurement data for diagnosis for the plurality of electrochemical modules 2. As a result, for each of the electrochemical modules 2 provided in the diagnosis system 1, the current and the voltage in a state where the inspection power is superimposed on the operation power are measured as measurement data for diagnosis.

In the embodiment and the like, the processing circuit 11 performs diagnosis by analyzing measurement data for diagnosis measured as described above for each of the plurality of electrochemical modules 2. FIG. 5 shows an example of processing in analysis of measurement data for diagnosis for an electrochemical module 2 performed by the processing circuit 11 of the diagnosis apparatus 10. In the embodiment and the like, also for other electrochemical modules 2, measurement data for diagnosis is analyzed in the same manner as in the example of FIG. 5 and the like. The analysis of the measurement data may be sequentially performed from the electrochemical module 2 in which the measurement data is measured, or may be performed after the measurement data is measured for all the electrochemical modules 2.

When the processing of the example of FIG. 5 is started, the processing circuit 11 measures the frequency characteristic of the impedance for the electrochemical module 2 by analyzing the measurement data for diagnosis (S121). At this time, the impedance of electrochemical module 2 is calculated based on the measurement results of the current and the voltage at each of the plurality of frequencies at which the current and the voltage of the electrochemical module 2 are measured. By calculating the impedance for the electrochemical module 2 at a plurality of frequencies, the frequency characteristics of the impedance for the electrochemical module 2 are measured. As the frequency characteristic of the impedance of electrochemical module 2, the frequency characteristic of the impedance of entire electrochemical module 2 may be measured, and in the configuration in which the plurality of electrochemical cells are electrically connected in the electrochemical module 2, the frequency characteristic of the impedance of each electrochemical cell may be measured.

The processing circuit 11 calculates a resistance component and the like of the electrochemical module 2 based on the measurement result of the frequency characteristic of the impedance for the electrochemical module 2 (S122). In an example, an equivalent circuit model for the electrochemical module 2 is stored in the storage medium 12, and in the equivalent circuit model, an electrical characteristic parameter including a resistance component in the electrochemical module 2 is set. In the equivalent circuit model, the relationship between the set electrical characteristic parameter and the impedance is shown, and for example, a relational expression for calculating the impedance for the electrochemical module 2 using the electrical characteristic parameter and the frequency is shown.

In the calculation of the resistance component and the like in the electrochemical module 2, the processing circuit 11 performs fitting calculation using, for example, the relationship between the electrical characteristic parameter and the impedance indicated by the equivalent circuit model and the measurement result of the frequency characteristic of the impedance for the electrochemical module 2. At this time, fitting calculation is performed using an electrical characteristic parameter set in an equivalent circuit model including a resistance component for the electrochemical module 2 as a variable, and an electrical characteristic parameter to be a variable is calculated. In addition, in the fitting calculation, the value of the electrical characteristic parameter to be a variable is calculated in a state where the difference between the arithmetic value calculated using the relationship indicated by the equivalent circuit model and the measurement value that is the measurement result is as small as possible at each of the plurality of frequencies at which the impedance is measured. By calculating the electrical characteristic parameter by fitting calculation, the resistance component and the like of the electrochemical module 2 are calculated.

Patent Literature 3 (Jpn. Pat. Appln. KOKAI Publication No. 2017-106889) discloses a method of performing fitting calculation using a measurement result of a frequency characteristic of impedance of a battery and a relationship between an electrical characteristic parameter (circuit constant) and the impedance indicated by an equivalent circuit model of the battery, calculating a value of the electrical characteristic parameter set by the equivalent circuit model, and calculating a resistance component of the battery. In the embodiment and the like, the resistance component of the electrochemical module 2 may be calculated in the same manner as the calculation of the resistance component of the battery in Patent Literature 3.

By calculating the resistance component of the electrochemical module 2, the deterioration state of the electrochemical module 2 can be determined based on, for example, the change amount of the calculated resistance component from the start of usage of the electrochemical module 2. In this case, for example, it is determined that the degree of deterioration of electrochemical module 2 is higher as the change amount of the calculated resistance component from the start of usage of the electrochemical module 2 is larger.

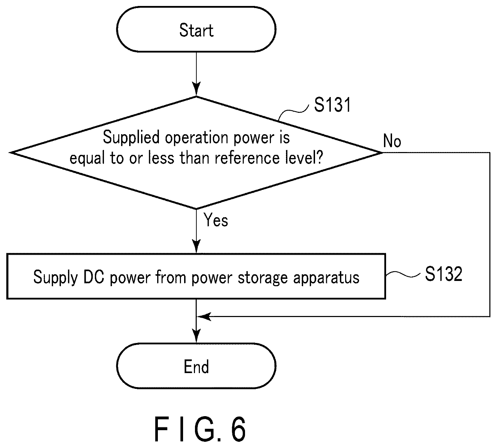

In addition, in a state where diagnosis is not performed, the processing circuit 11 controls power input to each of the electrochemical modules 2 by executing the output control program 17. FIG. 6 shows an example of processing of controlling power input to a certain electrochemical module 2, which is performed by the processing circuit 11 of the diagnosis apparatus 10 in a state where diagnosis is not performed. In the embodiment and the like, also for other electrochemical modules 2, the power to be input is controlled in a state where diagnosis is not performed, similarly to the example of FIG. 6 and the like. In addition, in a state where diagnosis is not performed, the processing of the example of FIG. 6 is repeatedly performed with time.

When the processing of the example of FIG. 6 is started, the processing circuit 11 or the like determines whether or not the operation power supplied to the electrochemical module 2 is equal to or less than the reference level (S131). The state in which the operation power is equal to or lower than the reference level. includes a state in which the operation power is input to the electrochemical module 2 at the level equal to or lower than the reference level, and a state in which the input of the operation power to the electrochemical module 2 is stopped. The processing circuit 11 acquires information on the operation power input to the electrochemical module 2 based on any one of the information from the distribution adjustment circuit 7 and the measurement results of the current and the voltage in the corresponding measurement circuit 5.

When the operation power to the electrochemical module 2 is equal to or less than the reference level (S131-Yes), the processing circuit 11 supplies the DC power from the power storage apparatus 21 to the electrochemical module 2 (S132). At this time, the DC power from the power storage apparatus 21 is input to the electrochemical module 2 without being converted by the output circuit 23 or the like. Therefore, the DC power from the power storage apparatus 21 is supplied to the electrochemical module 2 based on the fact that the operation power supplied to the electrochemical module 2 is equal to or less than the reference level. On the other hand, when the operation power to the electrochemical module 2 is higher than the reference level (S131-No), the processing of the example of FIG. 6 is ended without performing the processing of S132. Therefore, only the operation power is input to the electrochemical module 2, and no DC power or the like is supplied from the power storage apparatus 21.

As described above, in the embodiment, the inspection power is superimposed on the operation power by supplying the inspection power from the output circuit 23 to the electrochemical module 2 while the operation power is being input to the electrochemical module 2. Then, in a state where the inspection power is superimposed on the operation power, the measurement data for diagnosis is measured by measuring the current and the voltage for the electrochemical module 2. Therefore, by analyzing the measurement results of the current and the voltage for the electrochemical module 2 in a state where the inspection power is superimposed on the operation power as measurement data for diagnosis, the electrochemical module 2 is appropriately inspected. In addition, since the measurement is performed in a state where the inspection power is superimposed on the operation power, measurement data for diagnosis for the electrochemical module 2 is measured without stopping the operation of the electrochemical module 2. This makes it possible to appropriately inspect the electrochemical module 2 while continuing the operation of the electrochemical module 2. For example, it is possible to recover a product resulting from an electrochemical reaction in the electrochemical module 2 while measuring measurement data for diagnosis for the electrochemical module 2.

In the embodiment, the AC power in which the current value periodically changes is output from the output circuit as the inspection power, and the inspection power to be the AC power is superimposed on the operation power while sequentially changing the inspection power to a plurality of frequencies different from each other. Accordingly, the frequency characteristic of the impedance for the electrochemical module 2 can appropriately be measured based on the measurement result of the current and the voltage of the electrochemical module 2 in the state where the inspection power is superimposed on the operation power. By measuring the frequency characteristic of impedance for the electrochemical module 2, a resistance component and the like for the electrochemical module 2 can be appropriately estimated, and a deterioration state of the electrochemical module 2 and a deterioration state and the like of each of one or more electrochemical cells constituting the electrochemical module 2 can be appropriately determined.

In the embodiment, the PCS 6 to be the power regulator adjusts the operation power input to the electrochemical module 2 such that the current value in the electrochemical module 2 falls within the range of the reference variable width around the target current value. In a state where the inspection power is not superimposed on the operation power, the reference variable width is set to the first variable width W1, and in a state where the inspection power is superimposed on the operation power, the reference variable width is set to the second variable width W2 larger than the first variable width W1. The second variable width W2, which is the reference variable width in a state where the inspection power is superimposed on the operation power, is set to be larger than the variable width Wa of the current value in the AC power to be the inspection power. Therefore, in a state where the measurement data is measured by superimposing the inspection power on the operation power, the influence of superimposing the inspection power on the power adjustment in the PCS 6 is appropriately reduced.

In an example of the embodiment, in the state where the operation power is input to the plurality of electrochemical modules 2 in parallel, the electrochemical module 2 in which the inspection power is superimposed on the operation power is sequentially changed, and measurement data for diagnosis is sequentially measured for the plurality of electrochemical modules 2. Therefore, even when diagnosis is performed on the plurality of electrochemical modules 2, measurement data for diagnosis can be appropriately measured for each of the plurality of electrochemical modules 2 while each of the plurality of electrochemical modules 2 is operated, and the plurality of electrochemical modules 2 can be appropriately inspected.

In an example of the embodiment, the DC power from the power storage apparatus 21 is supplied to the electrochemical module 2 based on the fact that the operation power supplied to the electrochemical module 2 is equal to or less than the reference level. Therefore, the electrochemical module 2 can be appropriately operated even in a state where the supply of the operation power to the electrochemical module 2 through the power system 3 is stopped, a state in which the level of the operation power supplied to the electrochemical module 2 is low, and the like.

In the above-described embodiment and the like, the electrochemical reaction occurs in the electrochemical module 2 by inputting the operation power to the electrochemical module 2, but in a modification, the electrochemical module 2 may output the operation power generated by the electrochemical reaction. In this case, each of one or more electrochemical modules 2 supplies the output operation power through, for example, the power system 3. Also in the present modification, in the electrochemical module 2, each of the one or more electrochemical cells includes an anode and a cathode, and at least one of the anode and the cathode includes a catalyst. In addition, the electrochemical module 2 outputs DC power, and the output DC power is converted into AC power in a voltage range and a frequency range corresponding to the power system 3 by DC/AC conversion and transformation in the PCS 6 or the like which is a power regulator. Then, the converted AC power is supplied through the power system 3.

In an example, the electrochemical module 2 includes one or more fuel battery cells as electrochemical cells. In the electrochemical module 2, fuel such as hydrogen is supplied to the anode of each electrochemical cell, and oxygen is supplied to the cathode of each electrochemical cell. In each of the electrochemical cells, an electrochemical reaction occurs by supply of fuel and oxygen, a current is output from a cathode (positive electrode), and a current is input to an anode (negative electrode). As a result, the operation power is generated in the electrochemical module 2. Therefore, when the electrochemical module 2 is provided with a fuel battery cell, oxygen and fuel are supplied to the electrochemical module 2, thereby generating operation power output from the electrochemical module 2.

In the present modification, the processing circuit 11 or the like superimposes the inspection power on the operation power by supplying the inspection power from the output circuit 23 to the electrochemical module 2 while the operation power from the electrochemical module 2 is being output. Then, in a state where the inspection power is superimposed on the operation power, the measurement data for diagnosis is measured by measuring the current and the voltage for the electrochemical module 2. Therefore, also in the present modification, the measurement results of the current and the voltage of the electrochemical module 2 in the state where the inspection power is superimposed on the operation power are analyzed as the measurement data for diagnosis, whereby the electrochemical module 2 is appropriately inspected. In addition, since the measurement is performed in a state where the inspection power is superimposed on the operation power, measurement data for diagnosis for the electrochemical module 2 is measured without stopping the operation of the electrochemical module 2. This makes it possible to appropriately inspect the electrochemical module 2 while continuing the operation of the electrochemical module 2. For example, while measurement data for diagnosis is measured for the electrochemical module 2, the operation power generated by the electrochemical reaction can be output from the electrochemical module 2.

In the present modification, the PCS 6 as a power regulator adjusts the operation power output from the electrochemical module 2. Then, the PCS 6 adjusts the operation power such that the current value in the electrochemical module 2, that is, the current value of the current output from the electrochemical module 2 falls within the range of the reference variable width around the target current value. Also in the present modification, the reference variable width is set to the first variable width W1 in a state where the inspection power is not superimposed on the operation power, and the reference variable width is set to the second variable width W2 larger than the first variable width W1 in a state where the inspection power is superimposed on the operation power. The second variable width W2 is set to be larger than the variable width Wa of the current value in the AC power to be the inspection power. Therefore, also in the present modification, in a state where the measurement data is measured by superimposing the inspection power on the operation power, the influence of superimposing the inspection power on the power adjustment in the PCS 6 is appropriately reduced.

In a modification, a plurality of electrochemical modules 2 for outputting operation power generated by an electrochemical reaction are provided. In the state where the plurality of electrochemical modules 2 output the operation power in parallel, the electrochemical module 2 in which the inspection power is superimposed on the operation power is sequentially changed, and the measurement data for diagnosis is sequentially measured for the plurality of electrochemical modules 2. In the present modification, a connection adjustment circuit or the like is provided instead of the distribution adjustment circuit 7, and an electrical connection state of each electrochemical module 2 to the power system 3 can be switched by the connection adjustment circuit. In the state where the plurality of electrochemical modules 2 output the operation power in parallel, the connection adjustment circuit combines the power from the plurality of electrochemical modules 2, and supplies the combined power through the power system 3. In the present modification, while each of the plurality of electrochemical modules 2 is operated, measurement data for diagnosis for each of the plurality of electrochemical modules 2 can be appropriately measured, and the plurality of electrochemical modules 2 can be appropriately inspected.

In at least one of the above embodiments and examples, in a state where the operation power is input to the electrochemical module or the operation power is output from the electrochemical module, the inspection power is supplied from the output circuit to the electrochemical module, and the inspection power is superimposed on the operation power. Then, in a state where the inspection power is superimposed on the operation power, the measurement data for diagnosis is measured by measuring the current and the voltage for the electrochemical module. Accordingly, it is possible to provide a diagnosis apparatus, a diagnosis system, a diagnosis method, and a diagnosis program for an electrochemical module that enable appropriate inspection for the electrochemical module without stopping the operation of the electrochemical module.

Although some embodiments of the invention have been described, these embodiments are for purposes of illustration and are not intended to limit the scope of the invention. These novel embodiments may be implemented in various other forms and may be omitted, substituted, or changed in various ways without departing from the gist of the invention. These embodiments and modifications thereof are included in the scope and gist of the invention and are included in the invention disclosed in the claims and the equivalent scope thereof.

## Claims

1. A diagnosis apparatus for an electrochemical module in which at least one of an anode and a cathode includes a catalyst, in the electrochemical module, an electrochemical reaction occurring when operation power is input, or operation power generated by an electrochemical reaction being output, the diagnosis apparatus comprising:
an output circuit capable of outputting inspection power; and
a processor that, in a state in which the operation power is input to the electrochemical module or the operation power is output from the electrochemical module, superimposes the inspection power on the operation power by supplying the inspection power from the output circuit to the electrochemical module, and measures measurement data for diagnosis by measuring a current and a voltage for the electrochemical module in a state in which the inspection power is superimposed on the operation power.

2. The diagnosis apparatus according to claim 1, wherein the processor measures impedance for the electrochemical module based on measurement results of the current and the voltage for the electrochemical module measured as the measurement data for diagnosis.

3. The diagnosis apparatus according to claim 2, wherein
the processor outputs AC power in which a current value periodically changes from the output circuit as the inspection power, and superimposes the inspection power to be the AC power on the operation power while sequentially changing the inspection power to a plurality of frequencies different from each other, and
the processor measures a frequency characteristic of the impedance for the electrochemical module based on the measurement results of the current and the voltage for the electrochemical module.

4. The diagnosis apparatus according to claim 1, further comprising a power storage apparatus capable of storing power, wherein
the output circuit converts DC power from the power storage apparatus into the inspection power and outputs the inspection power to the electrochemical module.

5. The diagnosis apparatus according to claim 4, wherein
in the electrochemical module, the electrochemical reaction occurs by the supply of the operation power, and
the processor supplies the DC power from the power storage apparatus to the electrochemical module based on a fact that the operation power supplied to the electrochemical module is equal to or less than a reference level.

6. A diagnosis system comprising:
the diagnosis apparatus according to any one of claims 1 to 5; and
the electrochemical module including the anode and the cathode, at least one of the anode and the cathode including the catalyst, wherein the electrochemical reaction occurs when the operation power is input, or the operation power generated by the electrochemical reaction is output, and the measurement data for diagnosis is measured by measuring the current and the voltage by the diagnosis apparatus in a state where the inspection power is superimposed on the operation power by the diagnosis apparatus.

7. The diagnosis system according to claim 6, further comprising a power regulator that adjusts the operation power input to the electrochemical module or the operation power output from the electrochemical module, and adjusts the operation power to a state in which a current value in the electrochemical module falls within a range of a reference variable width around a target current value, wherein
the processor of the diagnosis apparatus sets the reference variable width to a first variable width in a state where the inspection power is not superimposed on the operation power, and sets the reference variable width to a second variable width larger than the first variable width in a state where the inspection power is superimposed on the operation power.

8. The diagnosis system according to claim 7, wherein
the processor of the diagnosis apparatus outputs AC power in which a current value periodically changes from the output circuit as the inspection power, and
the processor sets the second variable width, which is the reference variable width in a state where the inspection power is superimposed on the operation power, to be larger than a variable width of the current value in the AC power to be the inspection power.

9. The diagnosis system according to claim 6, wherein
the electrochemical module includes one or more electrochemical cells each including the anode and the cathode,
each of the one or more electrochemical cells is any of a water electrolysis cell that electrolyzes water when the operation power is input, a P2C cell that electrolyzes carbon dioxide when the operation power is input, and a fuel battery cell that generates the operation power output when oxygen and fuel are supplied.

10. The diagnosis system according to claim 6, further comprising a plurality of the electrochemical modules, wherein
the processor of the diagnosis apparatus sequentially changes the electrochemical module in which the inspection power is superimposed on the operation power and sequentially measures the measurement data for diagnosis for the plurality of electrochemical modules in a state in which the operation power is input to the plurality of electrochemical modules in parallel or in a state in which the operation power is output from the plurality of electrochemical modules in parallel.

11. A diagnosis method for an electrochemical module in which at least one of an anode and a cathode includes a catalyst, in the electrochemical module, an electrochemical reaction occurring when operation power is input, or operation power generated by an electrochemical reaction being output, the diagnosis method comprising:
superimposing inspection power on the operation power by supplying the inspection power from an output circuit to the electrochemical module in a state where the operation power is input to the electrochemical module or the operation power is output from the electrochemical module; and
measuring measurement data for diagnosis by measuring a current and a voltage for the electrochemical module in a state where the inspection power is superimposed on the operation power.

12. A diagnosis program for an electrochemical module in which at least one of an anode and a cathode includes a catalyst, in the electrochemical module, an electrochemical reaction occurring when operation power is input, or operation power generated by an electrochemical reaction being output, the diagnosis program causing a computer to execute:
superimposing inspection power on the operation power by supplying the inspection power from an output circuit to the electrochemical module in a state where the operation power is input to the electrochemical module or the operation power is output from the electrochemical module; and
measuring measurement data for diagnosis by measuring a current and a voltage for the electrochemical module in a state where the inspection power is superimposed on the operation power.

## Amended claims

### Amended claims under Art. 19.1 PCT

1. (Amended) A diagnosis system comprising:
an electrochemical module including an anode and a cathode, at least one of the anode and the cathode including a catalyst, wherein an electrochemical reaction occurs when operation power is input, or operation power generated by an electrochemical reaction is output;
an output circuit capable of outputting, as inspection power, AC power in which a current value periodically changes;
a power regulator that adjusts the operation power input to the electrochemical module or the operation power output from the electrochemical module, and adjusts the operation power to a state in which a current value in the electrochemical module falls within a range of a reference variable width around a target current value; and
a processor that superimposes the inspection power on the operation power by supplying the inspection power from the output circuit to the electrochemical module in a state where the operation power is input to the electrochemical module or the operation power is output from the electrochemical module, and measures measurement data for diagnosis by measuring a current and a voltage for the electrochemical module in a state where the inspection power is superimposed on the operation power, wherein the processor sets the reference variable width to be larger than a variable width of a current value in the AC power to be the inspection power in a state where the inspection power is superimposed on the operation power.

2. (Amended) The diagnosis system according to claim 1, wherein the processor measures impedance for the electrochemical module based on measurement results of the current and the voltage for the electrochemical module measured as the measurement data for diagnosis.

3. (Amended) The diagnosis system according to claim 2, wherein
the processor superimposes the inspection power to be the AC power on the operation power while sequentially changing the inspection power to a plurality of frequencies different from each other, and
the processor measures a frequency characteristic of the impedance for the electrochemical module based on the measurement results of the current and the voltage for the electrochemical module.

4. (Amended) The diagnosis system according to claim 1, further comprising a power storage apparatus capable of storing power, wherein
the output circuit converts DC power from the power storage apparatus into the inspection power and outputs the inspection power to the electrochemical module.

5. (Amended) The diagnosis system according to claim 4, wherein
in the electrochemical module, the electrochemical reaction occurs by the supply of the operation power, and
the processor supplies the DC power from the power storage apparatus to the electrochemical module based on a fact that the operation power supplied to the electrochemical module is equal to or less than a reference level.

6. (Canceled)

7. (Amended) The diagnosis system according to claim 1, wherein the processor of a diagnosis apparatus sets the reference variable width to a first variable width in a state where the inspection power is not superimposed on the operation power, and sets the reference variable width to a second variable width larger than the first variable width in a state where the inspection power is superimposed on the operation power.

8. (Canceled)

9. (Amended) The diagnosis system according to claim 1, wherein
the electrochemical module includes one or more electrochemical cells each including the anode and the cathode,
each of the one or more electrochemical cells is any of a water electrolysis cell that electrolyzes water when the operation power is input, a P2C cell that electrolyzes carbon dioxide when the operation power is input, and a fuel battery cell that generates the operation power output when oxygen and fuel are supplied.

10. (Amended) The diagnosis system according to claim 1, further comprising a plurality of the electrochemical modules, wherein
the processor a diagnosis apparatus sequentially changes the electrochemical module in which the inspection power is superimposed on the operation power and sequentially measures the measurement data for diagnosis for the plurality of electrochemical modules in a state in which the operation power is input to the plurality of electrochemical modules in parallel or in a state in which the operation power is output from the plurality of electrochemical modules in parallel.

11. (Amended) A diagnosis method for an electrochemical module in which at least one of an anode and a cathode includes a catalyst, in the electrochemical module, an electrochemical reaction occurring when operation power is input, or operation power generated by an electrochemical reaction being output, the diagnosis method comprising:
superimposing inspection power on the operation power by supplying AC power in which a current value periodically changes, as the inspection power, from an output circuit to the electrochemical module in a state where the operation power is input to the electrochemical module or the operation power is output from the electrochemical module;
measuring measurement data for diagnosis by measuring a current and a voltage for the electrochemical module in a state where the inspection power is superimposed on the operation power;
adjusting the operation power input to the electrochemical module or the operation power output from the electrochemical module, the operation power being adjusted to a state in which a current value in the electrochemical module falls within a range of a reference variable width around a target current value; and
setting the reference variable width to be larger than a variable width of a current value in the AC power to be the inspection power in a state where the inspection power is superimposed on the operation power.

12. (Amended) A diagnosis program for an electrochemical module in which at least one of an anode and a cathode includes a catalyst, in the electrochemical module, an electrochemical reaction occurring when operation power is input, or operation power generated by an electrochemical reaction being output, the diagnosis program causing a computer to execute:
superimposing inspection power on the operation power by supplying AC power in which a current value periodically changes, as the inspection power, from an output circuit to the electrochemical module in a state where the operation power is input to the electrochemical module or the operation power is output from the electrochemical module;
measuring measurement data for diagnosis by measuring a current and a voltage for the electrochemical module in a state where the inspection power is superimposed on the operation power;
adjusting the operation power input to the electrochemical module or the operation power output from the electrochemical module, and thereby adjusting the operation power to a state in which a current value in the electrochemical module falls within a range of a reference variable width around a target current value; and
setting the reference variable width to be larger than a variable width of a current value in the AC power to be the inspection power in a state where the inspection power is superimposed on the operation power.
